# EUROPEAN PATENT APPLICATION

(11) **EP 4 568 059 A1**
(43) Date of publication of application: **11.06.2025**
(21) Application number: 24210415.6
(22) Date of filing: 01.11.2024
(51) Int. Cl.: H02J 7/00, B60L 58/22, H01M 10/42

(54) **METHOD AND SYSTEM FOR CELL BALANCING AND SECONDARY BATTERIES INCLUDING SAME**

(30) Priority: 08.12.2023 KR 20230177600
(71) Applicant: SAMSUNG SDI CO., LTD., Yongin-si, Gyeonggi-do 17084 (KR)
(72) Inventor: LEE, Youngmin, 17084 Yongin-si (KR)
(74) Representative: Marks & Clerk LLP

(57) **Abstract**

A system for cell balancing includes a current measurement circuit (224) configured to measure current of a power consumption circuit (222) that consumes power of a first set of battery cells (260), a control signal generation circuit (226) configured to generate a control signal based on the current measured by the current measurement circuit (224) and a discharge circuit (242) electrically isolated from the control signal generation circuit (226), and configured to discharge a second set of battery cells (280) based on the control signal.

## Description

### BACKGROUND

### Field

Aspects of embodiments of the present disclosure relate to a method and system for cell balancing, and secondary batteries including same.

### Description of the Related Art

Unlike primary batteries that are not designed to be charged/recharged, secondary (or rechargeable) batteries are designed to be discharged and recharged. Low-capacity secondary batteries are used in portable, small electronic devices, such as smart phones, feature phones, notebook computers, digital cameras, and camcorders, while large-capacity secondary batteries are widely used as power sources for driving motors in hybrid vehicles and electric vehicles, and for storing power (e.g., home and/or utility scale power storage). A secondary battery generally includes an electrode assembly composed of a positive electrode and a negative electrode, a case accommodating the electrode assembly, and electrode terminals connected to the electrode assembly.

A battery pack may include a battery management module (BMM) that uses voltage of the battery cells as a power source for voltage and temperature measurements, and a battery management system (BMS) that communicates with the battery management module. With recent changes shifting communication between the BMM and the BSM to wireless communications, a radio frequency integrated circuit (RFIC) may be used for wireless communication in the BMM. The RFIC may be included in any one of a plurality of battery management integrated circuits (BMICs). In this case, the battery cells used as a power source for the BMIC including the RFIC may be discharged more than those used as power sources for other BMICs. Therefore, an imbalance among the battery cells may occur.

The above information disclosed in this Background section is for enhancement of understanding of the background of the present disclosure, and therefore, it may contain information that does not constitute related (or prior) art.

### SUMMARY

Embodiments of the present disclosure provide a method and system for cell balancing, and secondary batteries including the same.

These and other aspects and features of the present disclosure will be described in or will be apparent from the following description of some embodiments of the present disclosure.

A system for cell balancing according to one or more embodiments of the present disclosure comprises: a current measurement circuit configured to measure a current of a power consumption circuit configured to consume power of a first set of battery cells; a control signal generation circuit configured to generate a control signal based on the current measured by the current measurement circuit; and a discharge circuit electrically isolated from the control signal generation circuit, and configured to discharge a second set of battery cells based on the control signal.

In an embodiment, the power consumption circuit may correspond to or include a communication circuit in communication with an external battery management system.

In an embodiment, the current measurement circuit may include a shunt resistor connected to the power consumption circuit to measure a voltage drop associated with the current consumed by the power consumption circuit.

In an embodiment, the control signal generation circuit may include a current amplifier configured to amplify the voltage drop measured by the current measurement circuit.

In an embodiment, the control signal generation circuit may be configured to transmit the control signal to the discharge circuit, while maintaining an electrical isolation from the discharge circuit.

In an embodiment, the control signal generation circuit and the discharge circuit may include an optocoupler configured to transmit and receive the control signal.

According to one or more embodiments of the present disclosure, a secondary battery module includes: a first set of battery cells; a second set of battery cells different from the first set of battery cells; a first battery manager including a power consumption circuit associated with the first set of battery cells; and a second battery manager including a discharge circuit associated with the second set of battery cells. The first battery manager is configured to transmit a control signal associated with a power consumption of the first set of battery cells by the power consumption circuit to the second battery manager, and the second battery manager is configured to discharge the second set of battery cells using the discharge circuit based on the control signal.

In an embodiment, the power consumption circuit may include a communication circuit in communication with an external battery management system.

In an embodiment, the first battery manager may include a shunt resistor connected to the power consumption circuit to measure a voltage drop associated with a current consumed by the power consumption circuit.

In an embodiment, the first battery manager may be configured to generate the control signal by including a current amplifier to amplify the measured voltage drop.

In an embodiment, the first battery manager may be configured to transmit the control signal to the second battery manager, while maintaining an electrical isolation from the second battery manager.

In an embodiment, the second battery manager may include the discharge circuit to discharge an amount of current from the second set of battery cells corresponding to an amount of current consumed by the power consumption circuit.

In an embodiment, the second battery manager may be configured to control a discharge level of the second set of battery cells by the discharge circuit based on an operation mode of at least one of the first battery manager or the second battery manager.

According to one or more embodiments of the present disclosure, a method for cell balancing includes: generating, by a first battery manager, a control signal associated with a power consumption of a first set of battery cells by a power consumption circuit; transmitting, by the first battery manager, the control signal to a second battery manager including a discharge circuit connected to a second set of battery cells; and discharging, by the second battery manager, the second set of battery cells using the discharge circuit based on the control signal.

In an embodiment, the power consumption circuit may include a communication circuit in communication with an external battery management system.

In an embodiment, the generating of the control signal may include measuring, by a shunt resistor connected to the power consumption circuit, a voltage drop associated with a current consumed by the power consumption circuit.

In an embodiment, the generating of the control signal may include: amplifying, by a current amplifier, the voltage drop; and generating, by the first battery manager, the control signal based on the amplified voltage drop.

In an embodiment, the transmitting of the control signal to the second battery manager may include transmitting, by the first battery manager, the control signal to the second battery manager, while maintaining an electrical isolation from the second battery manager.

In an embodiment, the discharging of the second set of battery cells may include discharging, by the second battery manager, an amount of current from the second set of battery cells using the discharge circuit, the amount of current corresponding to an amount of current consumed by the power consumption circuit.

In an embodiment, the discharging of the second set of battery cells may include controlling, by the discharge circuit, a discharge level of the second set of battery cells based on an operation mode of at least one of the first battery manager or the second battery manager.

According to some embodiments of the present disclosure, an imbalance between the battery cells may be prevented or substantially prevented by consuming an amount of power through a discharge circuit of a second cell block that corresponds to an amount of power consumed by a power consumption circuit of a first cell block. Accordingly, the lifespan of the battery cells may be extended.

According to some embodiments of the present disclosure, a cell balancing operation may be performed through an isolated signal between the first battery manager and the second battery manager, which may be electrically isolated from each other. By using the isolation signal, a battery cell balancing system may be simply designed, without the addition of electrical circuits to physically connect the first battery manager and the second battery manager to each other. In other words, the circuits of a battery module including a plurality of cell blocks may not require significant design changes, which may result in lower costs, and cell balancing may be effectively performed at the hardware level.

However, the aspects and features of the present disclosure are not limited to those described above, and the above and other aspects and features will be set forth, in part, in the following detailed description with reference to the drawings, and in part, may be apparent therefrom, or may be learned by practicing one or more of the presented embodiments of the present disclosure.

At least some of the above and other features of the invention are set out in the claims.

### BRIEF DESCRIPTION OF DRAWINGS

The following drawings attached to this specification illustrate embodiments of the present disclosure, and further describe aspects and features of the present disclosure together with the detailed description of the present disclosure. Thus, the present disclosure should not be construed as being limited to the drawings.
FIG. 1 is a schematic block diagram illustrating an example of a secondary battery module including a cell balancing system according to one embodiment of the present disclosure.
FIG. 2 is a schematic diagram illustrating a circuit configuration of a secondary battery module including a cell balancing system according to one embodiment of the present disclosure.
FIG. 3 is a schematic diagram illustrating an example of a method of transmitting an isolation signal generated by one battery manager to a discharge circuit included in another battery manager according to one embodiment of the present disclosure.
FIG. 4 is a circuit diagram illustrating an example of a cell balancing system according to an embodiment of the present disclosure.
FIG. 5 is a diagram illustrating a simulation result of a cell balancing system according to an embodiment of the present disclosure.
FIG. 6 is a flow chart illustrating a method of cell balancing according to an embodiment of the present disclosure.

### DETAILED DESCRIPTION

Hereinafter, embodiments of the present disclosure will be described, in detail, with reference to the accompanying drawings. The terms or words used in this specification and claims should not be construed as being limited to the usual or dictionary meaning and should be interpreted as meaning and concept consistent with the technical idea of the present disclosure based on the principle that the inventor can be his/her own lexicographer to appropriately define the concept of the term to explain his/her invention in the best way.

The embodiments described in this specification and the configurations shown in the drawings are only some of the embodiments of the present disclosure and do not represent all of the technical ideas, aspects, and features of the present disclosure. Accordingly, it should be understood that there may be various equivalents and modifications that can replace or modify the embodiments described herein at the time of filing this application.

It will be understood that when a layer or element is referred to as being "between" two layers, it can be the only layer between the two layers, or one or more intervening layers may also be present. It will be understood that when an element or layer is referred to as being "on," "connected to," or "coupled to" another element or layer, it may be directly on, connected, or coupled to the other element or layer or one or more intervening elements or layers may also be present. When an element or layer is referred to as being "directly on," "directly connected to," or "directly coupled to" another element or layer, there are no intervening elements or layers present. For example, when a first element is described as being "coupled" or "connected" to a second element, the first element may be directly coupled or connected to the second element or the first element may be indirectly coupled or connected to the second element via one or more intervening elements.

In the figures, dimensions of the various elements, layers, etc. may be exaggerated for clarity of illustration. The same reference numerals designate the same elements. As used herein, the term "and/or" includes any and all combinations of one or more of the associated listed items. Further, the use of "may" when describing embodiments of the present disclosure relates to "one or more embodiments of the present disclosure." Expressions, such as "at least one of' and "any one of," when preceding a list of elements, modify the entire list of elements and do not modify the individual elements of the list. When phrases such as "at least one of A, B and C, "at least one of A, B or C," "at least one selected from a group of A, B and C," or "at least one selected from among A, B and C" are used to designate a list of elements A, B and C, the phrase may refer to any and all suitable combinations or a subset of A, B and C, such as A, B, C, A and B, A and C, B and C, or A and B and C. As used herein, the terms "use," "using," and "used" may be considered synonymous with the terms "utilize," "utilizing," and "utilized," respectively. As used herein, the terms "substantially," "about," and similar terms are used as terms of approximation and not as terms of degree, and are intended to account for the inherent variations in measured or calculated values that would be recognized by those of ordinary skill in the art.

It will be understood that, although the terms first, second, third, etc. may be used herein to describe various elements, components, regions, layers, and/or sections, these elements, components, regions, layers, and/or sections should not be limited by these terms. These terms are used to distinguish one element, component, region, layer, or section from another element, component, region, layer, or section. Thus, a first element, component, region, layer, or section discussed below could be termed a second element, component, region, layer, or section without departing from the teachings of example embodiments.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" or "over" the other elements or features. Thus, the term "below" may encompass both an orientation of above and below. The device may be otherwise oriented (rotated 90 degrees or at other orientations), and the spatially relative descriptors used herein should be interpreted accordingly.

The terminology used herein is for the purpose of describing embodiments of the present disclosure and is not intended to be limiting of the present disclosure. As used herein, the singular forms "a" and "an" are intended to include the plural forms as well, unless the context clearly indicates otherwise. It will be further understood that the terms "includes," "including," "comprises," and/or "comprising," when used in this specification, specify the presence of stated features, integers, steps, operations, elements, and/or components but do not preclude the presence or addition of one or more other features, integers, steps, operations, elements, components, and/or groups thereof.

Also, any numerical range disclosed and/or recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein, and any minimum numerical limitation recited in this specification is intended to include all higher numerical limitations subsumed therein. Accordingly, Applicant reserves the right to amend this specification, including the claims, to expressly recite any sub-range subsumed within the ranges expressly recited herein. All such ranges are intended to be inherently described in this specification such that amending to expressly recite any such subranges would comply with the requirements of 35 U.S.C. § 112(a) and 35 U.S.C. § 132(a).

References to two compared elements, features, etc. as being "the same" may mean that they are "substantially the same". Thus, the phrase "substantially the same" may include a case having a deviation that is considered low in the art, for example, a deviation of 5% or less. In addition, when a certain parameter is referred to as being uniform in a given region, it may mean that it is uniform in terms of an average.

Throughout the specification, unless otherwise stated, each element may be singular or plural.

Arranging an arbitrary element "above (or below)" or "on (under)" another element may mean that the arbitrary element may be disposed in contact with the upper (or lower) surface of the element, and another element may also be interposed between the element and the arbitrary element disposed on (or under) the element.

In addition, it will be understood that when a component is referred to as being "linked," "coupled," or "connected" to another component, the elements may be directly "coupled," "linked" or "connected" to each other, or another component may be "interposed" between the components".

Throughout the specification, when "A and/or B" is stated, it means A, B or A and B, unless otherwise stated. That is, "and/or" includes any or all combinations of a plurality of items enumerated. When "C to D" is stated, it means C or more and D or less, unless otherwise specified.

A battery pack according to one or more embodiments of the present disclosure includes at least one battery module, and a pack housing having an accommodation space in which the at least one battery module is accommodated.

The battery module may include a plurality of battery cells and a module housing. The battery cells may be accommodated inside the module housing in a stacked form (e.g., a stacked arrangement or configuration). Each battery cell may have a positive electrode terminal and a negative electrode terminal, and may be a circular type, a prismatic type, or a pouch type according to the shape of the battery. In the present specification, a battery cell may also be referred to as a secondary battery, a battery, or a cell.

In the battery pack, one cell stack may constitute one module that is stacked in place of the battery module. The cell stack may be accommodated in an accommodation space of the pack housing, or may be accommodated in an accommodation space partitioned by a frame, a partition wall, and/or the like.

The battery cell may generate a large amount of heat during charging/discharging. The generated heat may be accumulated in the battery cell, thereby accelerating the deterioration of the battery cell. Accordingly, the battery pack may further include a cooling member to remove the generated heat, and thereby, suppress the deterioration of the battery cell. The cooling member may be provided at the bottom of the accommodation space in which the battery cell is provided, but the present disclosure is not limited thereto, and the cooling member may be provided at the top or a side of the accommodation space depending on the battery pack.

The battery cell may be configured such that exhaust gas generated inside the battery cell under abnormal operating conditions, also known as thermal runaway or thermal events, is discharged to the outside of the battery cell. The battery pack or the battery module may include an exhaust port for discharging the exhaust gas to prevent or reduce damage to the battery pack or battery module by the exhaust gas.

The battery pack may include a battery, and a battery management system (BMS) for managing the battery. The battery management system may include a detection device, a balancing device, and a control device. The battery module may include a plurality of cells connected to each other in series and/or parallel. The battery modules may be connected to each other in series and/or in parallel.

The detection device may detect a state of a battery (e.g., a voltage, a current, a temperature, and/or the like) to output state information indicating the state of the battery. The detection device may detect the voltage of each cell constituting the battery or of each battery module. The detection device may detect a current flowing through each battery module constituting the battery module or the battery pack. The detection device may also detect the temperature of a cell and/or a module on at least one point of the battery, and/or an ambient temperature.

The balancing device may perform a balancing operation of a battery module and/or cells constituting the battery module. The control device may receive state information (e.g., a voltage, a current, a temperature, and/or the like) of the battery module from the detection device. The control device may monitor and calculate the state of the battery module (e.g., the voltage, the current, the temperature, a state of charge (SOC), a life span (e.g., a state of health (SOH)), and/or the like) on the basis of the state information received from the detection device. In addition, on the basis of the monitored state information, the control device may perform a control function (e.g., a temperature control, a balancing control, a charge/discharge control, and/or the like), and a protection function (e.g., over-discharge, over-charge, over-current protection, short circuit, a fire extinguishing function, and/or the like). In addition, the control device may perform a wired or wireless communication function with an external device (e.g., a higher level controller or vehicle, a charger, a power conversion system, and/or the like).

The control device may control charging/discharging operations and a protection operation of the battery. To this end, the control device may include a charge/discharge control unit (e.g., a charge/discharge control circuit or controller), a balancing control unit (e.g., a balancing control circuit or controller), and/or a protection unit (e.g., a protection circuit).

The battery management system monitors the battery state, and performs diagnosis and control, communication, and protection functions. The battery management system may calculate the charge/discharge state, may calculate battery life or state of health (SOH), may cut off, as necessary, a battery power (e.g., a relay control), may control thermal management (e.g., cooling, heating, and/or the like), may perform a high-voltage interlock function, and/or may detect and/or calculate insulation and short circuit conditions.

A relay may be a mechanical contactor that is turned on and off by the magnetic force of a coil or a semiconductor switch, such as a metal oxide semiconductor field effect transistor (MOSFET).

The relay control has a function of cutting off the power supply from the battery if (e.g., when) a problem occurs in the vehicle and the battery system, and may include one or more relays and pre-charge relays at the positive terminal and the negative terminal, respectively.

In the pre-charge control, a risk of an inrush current occurring in the high-voltage capacitor on the input side of the inverter when the battery load is connected. Thus, to prevent or substantially prevent the inrush current when starting a vehicle, the pre-charge relay may be operated before connecting the main relay, and the pre-charge resistor may be connected.

The high-voltage interlock is a circuit that uses a signal (e.g., a small signal) to detect whether or not all high-voltage parts of the entire vehicle system are connected, and may have a function of forcibly opening a relay if (e.g., when) an opening occurs at even one location on the entire loop.

The balancing device of the battery management system described above performs the balancing operation of the battery module and/or the battery cells at a software level. In contrast, the cell balancing system of the present disclosure is capable of independently performing the balancing operation of the battery cells itself within the battery management module (BMM). In other words, the cell balancing system according to embodiments of the present disclosure may perform the balancing operation of the battery cells at a hardware level.

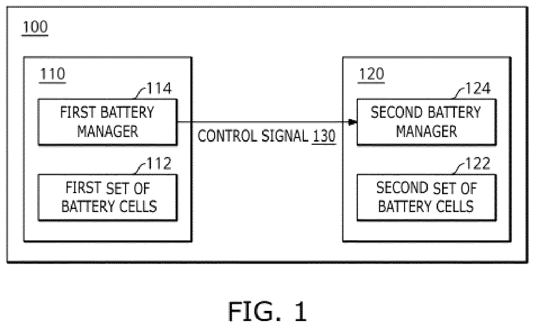

FIG. 1 is a schematic block diagram illustrating an example of a secondary battery module 100 including a cell balancing system according to an embodiment of the present disclosure. In one embodiment, the secondary battery module (e.g., the battery management module) 100 may include a first cell block 110 and a second cell block 120. The secondary battery module 100 may perform a cell balancing operation between the first cell block 110 and the second cell block 120.

In one embodiment, the first cell block 110 may include a first set of battery cells 112, and a first battery manager 114 connected to the first set of battery cells 112. In this case, the first battery manager 114 may include a power consumption circuit connected to the first set of battery cells 112. Here, the power consumption circuit may correspond to, but is not limited to, a communication circuit capable of communicating with an external battery management system (BMS), and may be any suitable component or circuit element that consumes power from the battery cells for communication with the BMS or for battery management purposes.

In one embodiment, the second cell block 120 may include a second set of battery cells 122, and a second battery manager 124 connected to the second set of battery cells 122. In this case, the second battery manager 124 may include a discharge circuit connected to the second set of battery cells 122. Here, the number of battery cells included in the second set of battery cells 122 may be the same as the number of battery cells in the first set of battery cells 112. For example, the number of battery cells in the first set of battery cells 112 and the number of battery cells in the second set of battery cells 122 may each be 16, but the present disclosure is not limited thereto.

In one embodiment, the first battery manager 114 may generate a control signal 130 associated with a power consumption of the first set of battery cells 112 by the power consumption circuit. Specifically, the control signal 130 may be associated with an amount of power consumed by the power consumption circuit. Further, the first battery manager 114 may transmit the control signal 130 to the second battery manager 124. In this case, the control signal 130 may be transmitted to the second battery manager 124 in an electrically isolated state.

In one embodiment, the second battery manager 124 may operate the discharge circuit in response to receiving the control signal 130. Specifically, the second battery manager 124 may discharge the second set of battery cells 122 using the discharge circuit based on the control signal 130. In this case, the second battery manager 124 may discharge the second set of battery cells 122 through a passive cell balancing, which utilizes the internal resistance of the discharge circuit to consume energy in the battery cells (e.g., the second set of battery cells 122). However, the present disclosure is not limited thereto, and the second battery manager 124 may discharge the second set of battery cells 122, for example, through a power consumption circuit of the second cell block 120.

In one embodiment, the second battery manager 124 may control a discharge level of the second set of battery cells 122 by the discharge circuit based further on the operation mode of at least one of the first battery manager 114 or the second battery manager 124. For example, in a case where the second battery manager 124 is in a sleep mode, the second battery manager 124 may reduce the discharge level of the second set of battery cells 122 through the discharge circuit. In this case, the cell balancing time through the discharge circuit may be increased.

With this configuration, an imbalance between the battery cells can be prevented or substantially prevented by consuming an amount of power through the discharge circuit of the second cell block 120 that corresponds to an amount of power consumed by the power consumption circuit of the first cell block 110. Accordingly, the lifespan of the battery cells may be extended.

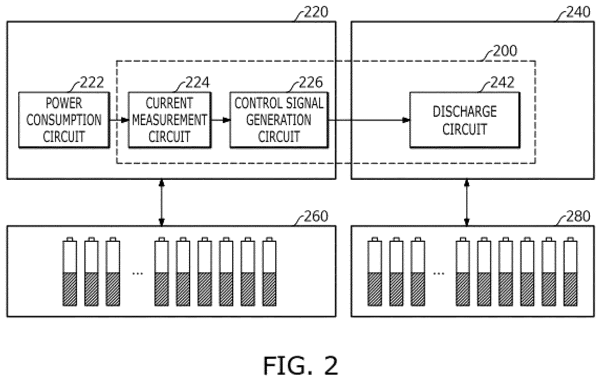

FIG. 2 is a schematic diagram illustrating a circuit configuration of a secondary battery module including a cell balancing system 200 according to an embodiment of the present disclosure. In one embodiment, a first battery manager 220 may include a power consumption circuit 222, a current measurement circuit 224, and a control signal generation circuit 226. Further, the second battery manager 240 may include a discharge circuit 242. In this case, the cell balancing system 200 may include the current measurement circuit 224, the control signal generation circuit 226, and the discharge circuit 242.

In one embodiment, each of the first battery manager 220 and the second battery manager 240 may be connected to a plurality of battery cells. For example, the first battery manager 220 may be connected to a first set of battery cells 260. Further, the second battery manager 240 may be connected to a second set of battery cells 280. Here, the number of battery cells included in each of the first set of battery cells 260 and the second set of battery cells 280 may be the same, but the present disclosure is not limited thereto.

In one embodiment, the power consumption circuit 222 may consume power from the first set of battery cells 260. Here, the power consumption circuit 222 may be, but is not limited to, a communication circuit (e.g., a radio frequency integrated circuit (RFIC)) for communicating with the battery management system. As the power is consumed from the first set of battery cells 260 by the power consumption circuit 222, an imbalance between the battery cells may occur between the first set of battery cells 260 and the second set of battery cells 280.

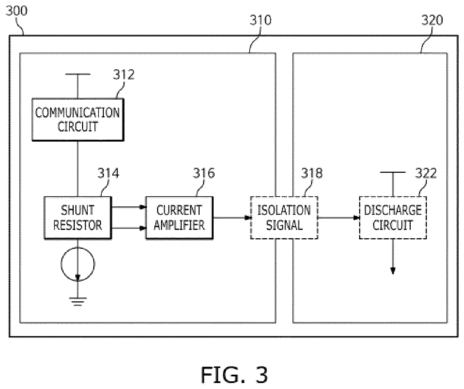

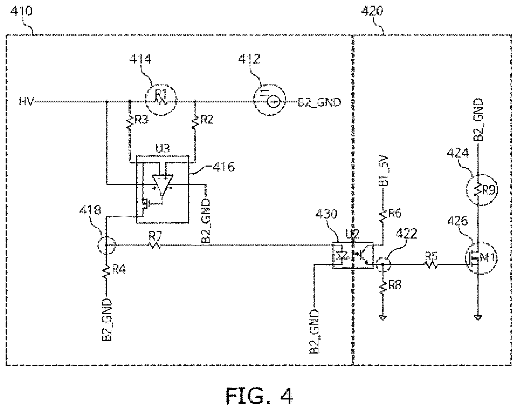

In one embodiment, the current measurement circuit 224 may measure the current consumed by the power consumption circuit 222. Further, the control signal generation circuit 226 may generate a control signal based on the current measured by the current measurement circuit 224. Thereafter, the control signal generation circuit 226 may transmit the control signal to the electrically isolated discharge circuit 242. The discharge circuit 242 may discharge the second set of battery cells 280 based on the control signal, so that the charging energy of the second set of battery cells 280 is adjusted to be equal to or substantially equal to the charging energy of the first set of battery cells 260. In FIG. 2, the current measurement circuit 224 and the control signal generation circuit 226 are illustrated as separate circuits from each other. However, the present disclosure is not limited thereto, and the current measurement circuit 224 and the control signal generation circuit 226 may be integrated together into the same circuit (e.g., into a single circuit). Examples of a method of measuring the current by the current measurement circuit 224 and a method of transmitting the control signal to the discharge circuit 242 by the control signal generation circuit 226 will be described in more detail below with reference to FIGS. 3 and 4.

FIG. 3 is a schematic diagram illustrating an example of a method of transmitting an isolation signal 318 generated by one battery manager to a discharge circuit 322 included in another battery manager in accordance with an embodiment of the present disclosure. In one embodiment, the secondary battery module 300 may include a first battery manager 310 and a second battery manager 320 that are electrically isolated from each other. Further, an isolation signal 318 associated with the current consumed by the first battery manager 310 may be transmitted to the second battery manager 320, while maintaining the electrical isolation.

In one embodiment, a power consumption circuit may consume power from battery cells connected to the first battery manager 310. For example, the power consumption circuit may be a communication circuit 312. In this case, a voltage drop associated with the current consumed by the communication circuit 312 may be measured using a shunt resistor 314 connected to the communication circuit 312. The shunt resistor 314 may have a small (e.g., a very small) resistance value to measure the current flowing in the circuit. Further, the measured voltage drop may be amplified by a current amplifier 316.

In one embodiment, the isolation signal 318 associated with a voltage value amplified by the current amplifier 316 may be transmitted to the discharge circuit 322. Here, the isolation signal 318 may be associated with an amount of current consumed by the communication circuit 312 in the first battery manager 310. In order to transmit the isolation signal 318 to the second battery manager 320, which is electrically isolated from the first battery manager 310, the isolation signal 318 may be transmitted in an electrically insulated state. For example, the isolation signal 318 may be transmitted from the first battery manager 310 to the second battery manager 320 using an optocoupler or the like, but the present disclosure is not limited thereto.

In one embodiment, the discharge circuit 322 may discharge the battery cells of the second battery manager 320 based on the received isolation signal 318. In this case, the discharge circuit 322 may utilize a resistor contained therein to perform a passive cell balancing operation. Here, a value of the resistor included in the discharge circuit 322 may be determined based on a difference between the current flowing in the circuit of the first battery manager 310 and the current flowing in the circuit of the second battery manager 320.

With this configuration, the cell balancing operation may be performed through an isolated signal (e.g., the isolation signal 318) between the first battery manager 310 and the second battery manager 320, that are electrically isolated from each other. By using the isolation signal 318, a battery cell balancing system can be simply designed, without the addition of electrical circuits to physically connect the first battery manager and the second battery manager to each other. In other words, the circuits of the battery module including a plurality of cell blocks may not require significant design changes, which may result in lower costs, and cell balancing may be effectively performed at the hardware level.

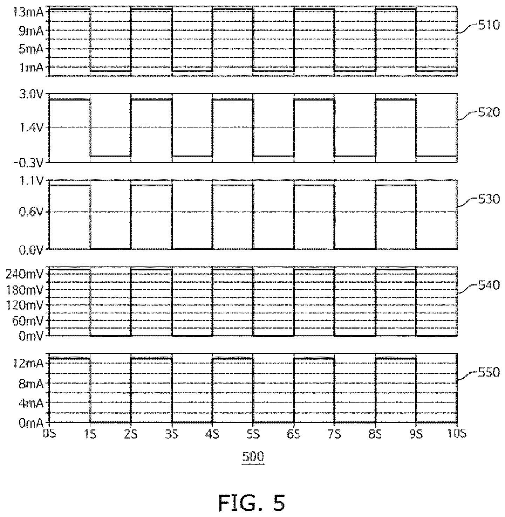

FIG. 4 is a circuit diagram illustrating an example of a cell balancing system according to an embodiment of the present disclosure, and FIG. 5 is a diagram illustrating a simulation result 500 of a cell balancing system according to an embodiment of the present disclosure. For example, the simulation result 500 may be an LTspice simulation result 500. In one embodiment, a first circuit of a first cell block 410 may measure the current consumed in a power consuming circuit, and may generate a control signal based thereon. Further, a second circuit of a second cell block 420 may discharge the battery cells based on the control signal.

In one embodiment, a voltage drop associated with the current consumed in the power consuming circuit may be measured through a shunt resistor (R1) 414 connected between a reference power source and a current source 412 in the power consuming circuit. The voltage drop may be amplified by an amplifier (U3) 416. Accordingly, a control signal associated with the amplified voltage drop may be transmitted to the second circuit through a light emitter of an optocoupler (U2) 430.

In one embodiment, the second circuit may include a light receiver of the optocoupler (U2) 430 for receiving the control signal from the first circuit. Here, the light receiver may detect light emitted from the light emitter of the optocoupler (U2) 430, and convert the detected light into an electrical signal. For example, the light emitter of the optocoupler (U2) 430 may include an LED, a laser diode, or the like, and the light receiver of the optocoupler (U2) 430 may include a light sensor, a photodiode, or the like.

In one embodiment, the second circuit may include a switching element (M1) 426 connected to the light receiver and the discharge circuit. Here, the switching element (M1) 426 may control a current flowing in the discharge circuit based on a control signal received from the light receiver. For example, the switching element (M1) 426 may include a field effect transistor (FET), but the present disclosure is not limited thereto. Thus, the second circuit may utilize an internal resistor (R9) 424 of the discharge circuit to perform a passive cell balancing operation.

In one embodiment, referring to FIG. 5, a first simulation result 510 indicates a pulse current of the second circuit flowing through the internal resistor (R9) 424 of the discharge circuit. A second simulation result 520 indicates a voltage at an output point (e.g., an output node) 422 of the light receiver after receiving a control signal through the optocoupler (U2) 430. Further, a third simulation result 530 indicates a voltage at an output point (e.g., an output node) 418 of the amplifier (U3) 416. A fourth simulation result 540 indicates a voltage across the shunt resistor (R1) 414, and a fifth simulation result 550 indicates a pulse current of the first circuit flowing in the current source 412. The first simulation result to the fifth simulation result 510 to 550 show that the first circuit exhibits a pulse current with the same period as that of the pulse current of the second circuit. This confirms that the cell balancing operation of the first cell block 410 and the second cell block 420 can be effectively performed by the cell balancing system according to one or more embodiments of the present disclosure.

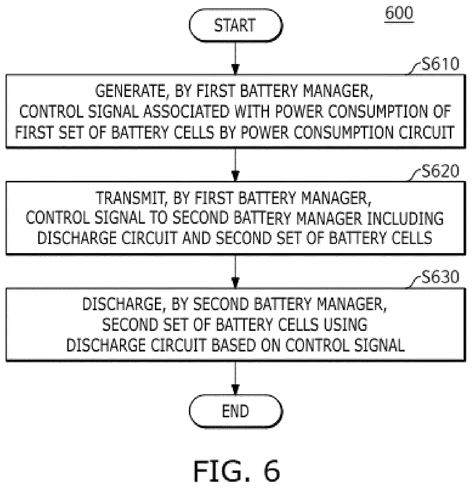

FIG. 6 is a flow chart illustrating a method 600 of cell balancing according to an embodiment of the present disclosure. In one embodiment, the method 600 may be performed by at least one processor. The method 600 may start, and a first battery manager (e.g., a processor of the first battery manager) may generate a control signal associated with a power consumption of a first set of battery cells by a power consumption circuit (S610). Here, the power consumption circuit may correspond to a communication circuit in communication with an external battery management system.

Specifically, the processor may measure, using a shunt resistor connected to the power consumption circuit, a voltage drop associated with a current consumed by the power consumption circuit. Further, the processor may amplify, using a current amplifier, the voltage drop. Further, the processor may generate the control signal based on the amplified voltage drop.

Thereafter, the first battery manager (e.g., the processor of the first battery manager) may transmit the control signal to a second battery manager including a discharge circuit connected to a second set of battery cells (S620). Specifically, the processor may transmit the control signal to the second battery manager from the first battery manager, while maintaining electrical isolation from the second battery manager.

Thereafter, the second battery manager (e.g., a processor of the second battery manager) may discharge the second set of battery cells using the discharge circuit based on the control signal (S630). Here, the second battery manager may discharge an amount of current corresponding to an amount of current consumed by the power consumption circuit from the second set of battery cells using the discharge circuit. Further, the processor may control a discharge level of the second set of battery cells by the discharge circuit based further on an operation mode of at least one of the first battery manager or the second battery manager.

The electronic or electric devices and/or any other relevant devices or components according to embodiments of the present disclosure described herein (e.g., the first battery manager, the second battery manager, the power consumption circuit, the power consuming circuit, the current measurement circuit, the control signal generation circuit, the discharge circuit, the communication circuit, the processor, and the like) may be implemented utilizing any suitable hardware, firmware (e.g. an application-specific integrated circuit), software, or a combination of software, firmware, and hardware. For example, the various components of these devices may be formed on one integrated circuit (IC) chip or on separate IC chips. Further, the various components of these devices may be implemented on a flexible printed circuit film, a tape carrier package (TCP), a printed circuit board (PCB), or formed on one substrate. Further, the various components of these devices may be a process or thread, running on one or more processors, in one or more computing devices, executing computer program instructions and interacting with other system components for performing the various functionalities described herein. The computer program instructions are stored in a memory which may be implemented in a computing device using a standard memory device, such as, for example, a random access memory (RAM). The computer program instructions may also be stored in other non-transitory computer readable media such as, for example, a CD-ROM, flash drive, or the like. Also, a person of skill in the art should recognize that the functionality of various computing devices may be combined or integrated into a single computing device, or the functionality of a particular computing device may be distributed across one or more other computing devices without departing from the scope of the example embodiments of the present disclosure.

The foregoing is illustrative of some embodiments of the present disclosure, and is not to be construed as limiting thereof. Although some embodiments have been described, those skilled in the art will readily appreciate that various modifications are possible in the embodiments without departing from the scope of the present disclosure. It will be understood that descriptions of features or aspects within each embodiment should typically be considered as available for other similar features or aspects in other embodiments, unless otherwise described. Thus, as would be apparent to one of ordinary skill in the art, features, characteristics, and/or elements described in connection with a particular embodiment may be used singly or in combination with features, characteristics, and/or elements described in connection with other embodiments unless otherwise specifically indicated. Therefore, it is to be understood that the foregoing is illustrative of various example embodiments and is not to be construed as limited to the specific embodiments disclosed herein, and that various modifications to the disclosed embodiments, as well as other example embodiments, are intended to be included within the scope of the present disclosure as defined in the appended claims, and their equivalents.

Embodiments are set out in the following clauses.

Clause 1. A system for cell balancing, comprising: a current measurement circuit configured to measure current of a power consumption circuit that consumes power of a first set of battery cells; a control signal generation circuit configured to generate a control signal based on the current measured by the current measurement circuit; and a discharge circuit electrically isolated from the control signal generation circuit, and configured to discharge a second set of battery cells based on the control signal.

Clause 2. The system of Clause 1, wherein the power consumption circuit corresponds to a communication circuit in communication with an external battery management system.

Clause 3. The system of Clause 1, wherein the current measurement circuit measures a voltage drop associated with the current consumed by the power consumption circuit using a shunt resistor connected to the power consumption circuit.

Clause 4. The system of Clause 3, wherein the control signal generation circuit includes a current amplifier configured to amplify the voltage drop measured by the current measurement circuit.

Clause 5. The system of Clause 1, wherein the control signal generation circuit transmits the control signal to the discharge circuit while maintaining electrical isolation from the discharge circuit.

Clause 6. The system of Clause 5, wherein the control signal generation circuit and the discharge circuit include an optocoupler configured to transmit and receive the control signal.

Clause 7. A secondary battery module including a cell balancing system, comprising: a first set of battery cells; a second set of battery cells different from the first set of battery cells; a first battery manager including a power consumption circuit associated with the first set of battery cells; and a second battery manager including a discharge circuit associated with the second set of battery cells, wherein the first battery manager transmits a control signal associated with power consumption of the first set of battery cells by the power consumption circuit to the second battery manager, wherein the second battery manager discharges the second set of battery cells using the discharge circuit based on the control signal.

Clause 8. The secondary battery module of Clause 7, wherein the power consumption circuit corresponds to a communication circuit in communication with an external battery management system.

Clause 9. The secondary battery module of Clause 7, wherein the first battery manager measures a voltage drop associated with current consumed by the power consumption circuit using a shunt resistor connected to the power consumption circuit.

Clause 10. The secondary battery module of Clause 9, wherein the first battery manager generates the control signal by amplifying the measured voltage drop using a current amplifier.

Clause 11. The secondary battery module of Clause 7, wherein the first battery manager transmits the control signal to the second battery manager while maintaining electrical isolation from the second battery manager.

Clause 12. The secondary battery module of Clause 7, wherein the second battery manager uses the discharge circuit to discharge an amount of current from the second set of battery cells corresponding to an amount of current consumed by the power consumption circuit.

Clause 13. The secondary battery module of Clause 7, wherein the second battery manager controls a discharge level of the second set of battery cells by the discharge circuit based further on an operation mode of at least one of the first battery manager or the second battery manager.

Clause 14. A method for cell balancing, comprising: generating, by a first battery manager, a control signal associated with power consumption of a first set of battery cells by a power consumption circuit; transmitting, by the first battery manager, the control signal to a second battery manager including a discharge circuit connected to a second set of battery cells; and discharging, by the second battery manager, the second set of battery cells using the discharge circuit based on the control signal.

Clause 15. The method of Clause 14, wherein the power consumption circuit corresponds to a communication circuit in communication with an external battery management system.

Clause 16. The method of Clause 14, wherein the generating the control signal comprises: measuring, by a shunt resistor connected to the power consumption circuit, a voltage drop associated with current consumed by the power consumption circuit.

Clause 17. The method of Clause 16, wherein the generating the control signal comprises: amplifying, by a current amplifier, the voltage drop; and generating the control signal based on the amplified voltage drop.

Clause 18. The method of Clause 14, wherein the transmitting the control signal to the second battery manager comprises: transmitting, by the first battery manager, the control signal to the second battery manager while maintaining electrical isolation from said second battery manager.

Clause 19. The method of Clause 14, wherein the second battery manager discharges an amount of current corresponding to an amount of current consumed by the power consumption circuit from the second set of battery cells using the discharge circuit.

Clause 20. The method of Clause 14, wherein the discharging the second set of battery cells comprises: controlling a discharge level of the second set of battery cells by the discharge circuit based further on an operation mode of at least one of the first battery manager or the second battery manager.

### DESCRIPTION OF SOME REFERENCE SYMBOLS

- 100:: secondary battery module
- 110:: first cell block
- 112:: first set of battery cells
- 114:: first battery manager
- 120:: second cell block
- 122:: second set of battery cells
- 124:: second battery manager
- 130:: control signal

## Claims

1. A system for cell balancing, comprising:
a current measurement circuit configured to measure a current of a power consumption circuit configured to consume power of a first set of battery cells;
a control signal generation circuit configured to generate a control signal based on the current measured by the current measurement circuit; and
a discharge circuit electrically isolated from the control signal generation circuit, and configured to discharge a second set of battery cells based on the control signal.

2. The system as claimed in claim 1, wherein the power consumption circuit corresponds to or comprises a communication circuit in communication with an external battery management system.

3. The system as claimed in claim 1 or 2, wherein the current measurement circuit comprises a shunt resistor connected to the power consumption circuit to measure a voltage drop associated with the current consumed by the power consumption circuit,
and wherein optionally the control signal generation circuit includes a current amplifier configured to amplify the voltage drop measured by the current measurement circuit.

4. The system as claimed in any preceding claim, wherein the control signal generation circuit is configured to transmit the control signal to the discharge circuit, while maintaining an electrical isolation from the discharge circuit,
and wherein optionally the control signal generation circuit and the discharge circuit include an optocoupler configured to transmit and receive the control signal.

5. A secondary battery module comprising:
a first set of battery cells;
a second set of battery cells different from the first set of battery cells;
a first battery manager including a power consumption circuit associated with the first set of battery cells; and
a second battery manager including a discharge circuit associated with the second set of battery cells,
wherein the first battery manager is configured to transmit a control signal associated with a power consumption of the first set of battery cells by the power consumption circuit to the second battery manager, and
wherein the second battery manager is configured to discharge the second set of battery cells using the discharge circuit based on the control signal.

6. The secondary battery module as claimed in claim 5, wherein the power consumption circuit comprises a communication circuit in communication with an external battery management system.

7. The secondary battery module as claimed in claim 5 or 6, wherein the first battery manager comprises a shunt resistor connected to the power consumption circuit to measure a voltage drop associated with a current consumed by the power consumption circuit,
and wherein optionally the first battery manager is configured to generate the control signal by comprising a current amplifier to amplify the measured voltage drop.

8. The secondary battery module as claimed in claim 5, 6 or 7, wherein the first battery manager is configured to transmit the control signal to the second battery manager, while maintaining an electrical isolation from the second battery manager.

9. The secondary battery module as claimed in any one of claims 5 to 8, wherein the second battery manager comprises the discharge circuit to discharge an amount of current from the second set of battery cells corresponding to an amount of current consumed by the power consumption circuit.

10. The secondary battery module as claimed in any one of claims 5 to 9, wherein the second battery manager is configured to control a discharge level of the second set of battery cells by the discharge circuit based on an operation mode of at least one of the first battery manager or the second battery manager.

11. A method for cell balancing, comprising:
generating, by a first battery manager, a control signal associated with a power consumption of a first set of battery cells by a power consumption circuit;
transmitting, by the first battery manager, the control signal to a second battery manager comprising a discharge circuit connected to a second set of battery cells; and
discharging, by the second battery manager, the second set of battery cells using the discharge circuit based on the control signal.

12. The method as claimed in claim 11, wherein the power consumption circuit comprises a communication circuit in communication with an external battery management system.

13. The method as claimed in claim 14, wherein the generating of the control signal comprises measuring, by a shunt resistor connected to the power consumption circuit, a voltage drop associated with a current consumed by the power consumption circuit,
and wherein optionally the generating of the control signal comprises:
amplifying, by a current amplifier, the voltage drop; and
generating, by the first battery manager, the control signal based on the amplified voltage drop.

14. The method as claimed in claim 11, 12 or 13, wherein the transmitting of the control signal to the second battery manager comprises transmitting, by the first battery manager, the control signal to the second battery manager, while maintaining an electrical isolation from the second battery manager.

15. The method as claimed in claim 14, wherein the discharging of the second set of battery cells comprises at least one of:
discharging, by the second battery manager, an amount of current from the second set of battery cells using the discharge circuit, the amount of current corresponding to an amount of current consumed by the power consumption circuit; and/or
controlling, by the discharge circuit, a discharge level of the second set of battery cells based on an operation mode of at least one of the first battery manager or the second battery manager.
